# DEMANDE DE BREVET EUROPEEN

(11) **EP 3 985 719 A1**
(43) Date de publication de la demande: **20.04.2022**
(21) Numéro de dépôt: 21202231.3
(22) Date de dépôt: 12.10.2021
(51) Int. Cl.: H01L 23/00, H01L 25/065, H01L 25/18, H01L 25/00, H01L 23/552, H01L 25/16

(54) **BOITIER-SYSTEME ELECTRONIQUE COMPRENANT DES FACES LATERALES PROTEGEES**

(30) Priorité: 13.10.2020 FR 2010455
(71) Demandeur: Commissariat à l'énergie atomique et aux énergies alternatives, 75015 Paris (FR)
(72) Inventeur: SOHIER, Thibaut, 38054 GRENOBLE CEDEX 09 (FR); BOREL, Stephan, 38054 GRENOBLE CEDEX 09 (FR)
(74) Mandataire: Brevalex

(57) **Abrégé**

Boîtier-système électronique (100), comportant au moins :
- un support (102) ;
- une ou plusieurs puces (106.1, 106.2) couplées mécaniquement et électriquement à une face avant (104) du support ;
- un matériau d'encapsulation (108) recouvrant la face avant du support et encapsulant la ou les puces ;
- plusieurs éléments de protection latéraux (110), comprenant un matériau opaque, et entourant latéralement la ou les puces et configurés pour former une barrière au moins vis-à-vis d'attaques par laser réalisées à travers des faces latérales (112) du boîtier-système électronique qui sont sensiblement perpendiculaires à la face avant du support ;
et dans lequel les éléments de protection latéraux sont disposés dans le matériau d'encapsulation ou dans un ou plusieurs premiers blocs (114) de matériau distincts du support et disposés dans le matériau d'encapsulation.

## Description

### DOMAINE TECHNIQUE

L'invention concerne le domaine de la protection de boîtiers-systèmes électroniques, ou SiP (« System in Package » en anglais), vis-à-vis d'attaques mises en œuvre dans le but d'accéder à des informations sensibles stockées dans le système ou de porter atteinte à son fonctionnement. L'invention porte sur un boîtier-système électronique comportant des moyens de protection de ses faces latérales empêchant l'accès au(x) circuit(s) intégré(s) du boîtier-système électronique depuis ces faces latérales protégées.

### ÉTAT DE LA TECHNIQUE ANTÉRIEURE

Un boîtier-système électronique, ou SiP, correspond à un ensemble de puces, qui sont des circuits intégrés et/ou qui comportent d'autres composants (passifs, MEMS, etc...), enfermées dans un même boîtier ou module, disposées les unes à côté des autres et/ou les unes au-dessus des autres sur un support, et connectées électriquement entre elles et/ou à des connexions extérieures au boîtier-système électronique par des fils et/ou par flip-chip (ou puce retournée).

Nous désignerons par face avant du boîtier-système électronique la face située du côté où les puces sont disposées sur le support, quel que soit le sens dans lequel celles-ci sont positionnées contre le support. Nous désignerons par face arrière du boîtier-système électronique la face opposée, c'est-à-dire celle du côté de laquelle se trouvent les connexions, par exemple des billes de connexion, destinées à reporter le boîtier-système électronique sur une carte d'application ou circuit imprimé (PCB pour « Printed Circuit Board » en anglais).

Un boîtier-système électronique peut être attaqué de façon logicielle ou matérielle. Dans le second cas, les attaques, dites physiques, peuvent s'opérer de diverses manières : chimique, laser, électromagnétique, électrique, etc.

Certaines attaques, dites non-invasives ou par canaux auxiliaires, n'impliquent pas une introduction dans le boîtier-système électronique attaqué. Ces attaques consistent à mesurer des données extérieures au boîtier-système électronique : mesure de sa consommation électrique, mesure des émissions électromagnétiques émanant du boîtier-système électronique, mesure de la chaleur émise par le boîtier-système électronique, etc.

D'autres attaques, dites semi-invasives, impliquent une introduction modérée dans le boîtier-système électronique attaqué qui reste, après ces attaques, opérationnel ou fonctionnel, comme par exemple les attaques par injection de fautes à l'aide d'un laser (impulsion lumineuse). Ces attaques se font aussi bien par la face avant du boîtier-système électronique que par sa face arrière.

Enfin, d'autres attaques, dites invasives, impliquent de détruire partiellement le boîtier attaqué, comme par exemple les attaques par probing (ou par sonde) et la rétro-conception. Ces attaques impliquent un accès et une modification irréversible du circuit qui peut rester fonctionnel ou non après ces attaques.

Les attaques par laser ou par effet photo-électrique sont actuellement les attaques physiques les plus communément perpétrées en raison de la généralisation des outils permettant de mettre en œuvre ce type d'attaques. Le plus souvent, une telle attaque consiste à exciter une région du circuit du boîtier-système électronique qui comporte au moins un transistor de sorte à le faire changer d'état. Le laser utilisé émet par exemple, dans le cas des attaques face arrière, dans le proche infrarouge. Ce changement d'état inopiné du transistor induit des erreurs, ou fautes, dans l'exécution d'une ou plusieurs opérations mises en œuvre dans le circuit attaqué. Si celles-ci correspondent à des opérations de chiffrement/déchiffrement, il est possible, en analysant les valeurs erronées obtenues, de retrouver des informations relatives à la clé de chiffrement (c'est-à-dire la valeur des bits qui la constituent) utilisée par le circuit attaqué.

Pour contrer les attaques par laser réalisées depuis la face avant d'une puce ou d'un boîtier-système électronique, il a notamment été proposé d'ajouter en face avant des détecteurs de lumière à base de diodes. D'autres contremesures, telles que les couches « antiprobing », formées par exemple d'un serpentin sur lequel une mesure continue de la résistance électrique est réalisée, permettent de vérifier qu'une région de la face avant n'a pas été endommagée dans le but de former un accès au circuit pour le faisceau laser.

Confrontés à des protections de plus en plus efficaces en face avant des composants, les attaquants ont été amenés à développer des techniques d'attaque en face arrière des composants. Des solutions similaires de protection ont donc également été proposées au niveau de la face arrière des puces ou des boîtiers-systèmes électroniques.

Les attaques par ondes électromagnétiques consistent généralement à réaliser soit une injection de faute dans les composants du boîtier-système électronique attaqué via des impulsions électromagnétiques, soit à déduire la valeur des bits composant une clé de chiffrement à partir d'observations du champ électromagnétique émis par le système en fonctionnement. Il existe des solutions pour contrer ce type d'attaque, comme par exemple la réalisation d'un blindage électromagnétique sur une ou plusieurs faces du boîtier-système électronique ou encore l'émission d'ondes électromagnétiques parasites afin de brouiller le spectre électromagnétique émanant du boîtier-système électronique.

Les faces latérales des boîtiers-systèmes électroniques restent toutefois vulnérables aux attaques car les solutions décrites ci-dessus pour protéger les faces avant et arrière ne sont pas adaptées pour protéger les faces latérales.

Le document US 2007/018334 A1 décrit une solution de protection de toutes les faces d'un système constitué d'un boîtier BGA reporté sur PCB, cette protection utilisant les connexions électriques traversant le boîtier ainsi que les billes de connexion du boîtier et également les éléments du PCB (pistes conductrices dans le plan horizontal et connexions traversantes verticales). Cette solution n'est toutefois pas adaptée à tous les types de boîtiers-systèmes. En effet, la présence de connexions électriques traversant le boîtier est une spécificité des boîtiers de type « cavity down » tel que décrit dans ce document, tandis que les boîtiers BGA standards ne disposent généralement pas de telles connexions. De plus, cette solution n'est pas optimale pour former une protection vis-à-vis des attaques par sondage ou par ondes électromagnétiques.

### EXPOSÉ DE L'INVENTION

Un but de la présente invention est de proposer un boîtier-système électronique dont les faces latérales soient protégées au moins vis-à-vis d'attaques par laser, et dont les moyens de protection des faces latérales puissent être adaptés à tous les types de boîtiers-systèmes électroniques.

Pour cela, la présente invention propose un boîtier-système électronique, comportant au moins :
- un support;
- une ou plusieurs puces couplées mécaniquement et électriquement à une face avant du support ;
- des éléments de contact électrique disposés au niveau d'une face arrière, opposée à la face avant, du support et couplés électriquement à la ou aux puces ;
- un matériau d'encapsulation recouvrant la face avant du support et encapsulant, ou recouvrant, la ou les puces, et/ou un capot formant, au moins avec le support, au moins une cavité dans laquelle la ou les puces sont disposées ;
- plusieurs éléments de protection latéraux comprenant au moins un matériau opaque, entourant latéralement la ou les puces et configurés pour former une barrière au moins vis-à-vis d'attaques par laser réalisées à travers des faces latérales du boîtier-système électronique qui sont sensiblement perpendiculaires à la face avant du support ;
et dans lequel les éléments de protection latéraux sont disposés dans le matériau d'encapsulation ou dans un ou plusieurs premiers blocs de matériau distincts du support et disposés dans le matériau d'encapsulation et/ou entre le support et le capot.

L'invention propose de réaliser plusieurs éléments de protection latéraux dans le matériau d'encapsulation (directement ou dans des premiers blocs de matériau eux-mêmes disposés dans le matériau d'encapsulation) et/ou entre le support et le capot (dans des premiers blocs de matériau disposés entre le support et le capot) du boîtier-système électronique pour former une barrière opaque protégeant la ou les puces du boîtier-système vis-à-vis des attaques par laser, notamment de type LLFI ou « Lateral Laser Fault Injection » en anglais.

De tels éléments de protection peuvent être réalisés dans n'importe quel type de boîtier-système électronique.

Les éléments de protections latéraux ne servent pas au transit d'informations, ou signaux utiles, de la ou des puces du boîtier-système électronique.

Le matériau des éléments de protection latéraux est qualifié d'opaque car il ne peut pas être traversé par un faisceau laser dont la longueur est par exemple comprise entre 360 nm et 1064 nm.

Le matériau d'encapsulation peut également correspondre à un matériau opaque, c'est-à-dire un matériau ne pouvant pas être traversé par un faisceau laser dont la longueur est par exemple comprise entre 360 nm et 1064 nm.

Le terme « puce » désigne ici et dans tout le document, un ensemble de composants actifs et/ou passifs, électroniques et/ou électromécaniques (comme par exemple un ou plusieurs MEMS). La puce électronique peut correspondre à un circuit intégré et/ou peut comporter d'autres composants (passifs, MEMS, etc...).

De manière avantageuse, le matériau des éléments de protection latéraux peut être électriquement conducteur. Cette configuration est très avantageuse car les éléments de protection latéraux forment dans ce cas, en plus d'une barrière optique, un blindage électromagnétique permettant une protection efficace du boîtier-système électronique contre les attaques électromagnétiques en empêchant l'injection de fautes par ondes électromagnétiques et la lecture des émissions électromagnétiques émanant des composants du boîtier-système électronique. En outre, cette configuration permet de rendre actifs les éléments de protection latéraux, c'est-à-dire d'en mesurer certaines grandeurs caractéristiques (résistance ou impédance selon les conditions, par exemple) permettant de juger de leur intégrité.

De manière avantageuse, le matériau des éléments de protection latéraux peut correspondre à un matériau magnétique ou à une combinaison de matériaux magnétiques et non-magnétiques.

Outre les éléments de protection latéraux, il est possible que le boîtier-système électronique comporte d'autres éléments opaques ne faisant pas partie de la protection latérale du boîtier-système électronique.

Le boîtier-système électronique peut comporter en outre au moins une couche de protection avant du boîtier-système électronique, disposée dans le matériau d'encapsulation, du côté d'une face avant du boîtier-système électronique et en regard de la ou des puces, et comprenant plusieurs portions de matériau électriquement conducteur s'étendant dans au moins un plan parallèle à la face avant du boîtier-système électronique selon au moins un motif de serpentin.

En variante, le boîtier-système électronique peut comporter au moins une couche de protection avant du boîtier-système électronique non électriquement active, c'est-à-dire qui ne comporte pas de matériau électriquement conducteur ou comportant des portions de matériau électriquement conducteur qui ne sont pas reliées électriquement entre elles et/ou au reste du système.

La couche de protection avant du boîtier-système électronique peut s'étendre dans un ou plusieurs niveaux superposés au-dessus de la ou des puces du boîtier-système électronique.

Le boîtier-système électronique peut comporter en outre une couche de redistribution, ou couche de reroutage ou RDL pour « Redistribution Layer» en anglais, interposée entre la face avant du support et la ou les puces et/ou disposée au moins en partie dans le support, et à laquelle la ou les puces sont reliées électriquement.

Dans ce cas, des premières portions de la couche de redistribution peuvent former des éléments de liaison électrique reliant électriquement au moins une partie des éléments de protection latéraux entre eux, et, lorsque le boîtier-système électronique comporte la couche de protection avant, les éléments de protection latéraux peuvent être reliés électriquement aux portions de matériau électriquement conducteur de la couche de protection avant en formant un ou plusieurs chemins de conduction dont la résistance électrique ou l'impédance, selon que le courant circulant dans les portions de matériau électriquement conducteur de la couche de protection avant du boîtier-système électronique et dans les éléments de protection latéraux soit continu (pour la résistance électrique) ou alternatif (pour l'impédance), peut être mesurée. Dans cette configuration, la couche de protection avant coopère avec les éléments de protection latéraux pour former un capot protecteur actif empêchant les attaques de la ou des puces à travers la face avant et les faces latérales du boîtier-système électronique.

Le boîtier-système électronique peut comporter en outre des éléments de connexion reliant électriquement la couche de protection avant à la couche de redistribution, entourés par les éléments de protection latéraux et disposés dans le matériau d'encapsulation ou dans au moins un deuxième bloc de matériau distinct du support et disposé dans le matériau d'encapsulation et/ou entre le support et le capot.

Les éléments de connexion peuvent être réalisés à partir du même matériau que celui des éléments de protection latéraux. Les éléments de connexion peuvent servir notamment à relier électriquement la couche de protection avant à la ou à l'une des puces qui mesure l'impédance ou la résistance électrique de la couche de protection avant du boîtier-système et des éléments de protection latéraux.

Des deuxièmes portions de la couche de redistribution peuvent former au moins une couche de protection arrière du boîtier-système électronique disposée en regard de la ou des puces, lesdites deuxièmes portions de la couche de redistribution étant reliées électriquement aux éléments de protection latéraux.

Ainsi, les couches de protection avant et arrière du boîtier-système électronique et les éléments de protection latéraux forment une enceinte sécuritaire dans laquelle la ou les puces du boîtier-système électronique sont disposées, protégeant toutes les faces du boîtier-système électronique.

De manière avantageuse, au niveau de chacune des faces latérales du boîtier-système électronique, les éléments de protection latéraux peuvent être disposés en quinconce et en plusieurs rangées parallèles à ladite face latérale du boîtier-système électronique. Cet agencement des éléments de protection latéraux est avantageux car il complexifie la réalisation d'un détour de fil sur les éléments latéraux ainsi que l'accès à un faisceau laser entre les éléments de protection latéraux.

L'invention concerne également un procédé de réalisation d'un boîtier-système électronique, comportant au moins les étapes suivantes :
- couplage mécanique et électrique d'une ou plusieurs puces à une face avant d'un support ;
- dépôt d'un matériau d'encapsulation recouvrant la face avant du support et encapsulant la ou les puces, et/ou réalisation d'un capot formant, au moins avec le support, au moins une cavité dans laquelle la ou les puces sont disposées ;
- réalisation d'éléments de contact électrique disposés au niveau d'une face arrière, opposée à la face avant, du support et couplés électriquement à la ou aux puces;
et comportant en outre la réalisation de plusieurs éléments de protection latéraux comprenant au moins un matériau opaque, entourant latéralement la ou les puces et configurés pour former une barrière au moins vis-à-vis d'attaques par laser réalisées à travers des faces latérales du boîtier-système électronique qui sont sensiblement perpendiculaires à la face avant du support, les élément de protection latéraux étant disposés dans le matériau d'encapsulation ou dans un ou plusieurs premiers blocs de matériau distincts du support et disposés dans le matériau d'encapsulation et/ou entre le support et le capot.

En outre, les éléments de protection latéraux comportent au moins un matériau opaque vis-à-vis d'un faisceau laser de longueur d'onde comprise entre 360 nm et 1064 nm.

La réalisation des éléments de protection latéraux peut comporter, après le dépôt du matériau d'encapsulation :
- réalisation de cavités dans le matériau d'encapsulation ;
- dépôt du matériau opaque dans les cavités, formant les éléments de protection latéraux.

De manière alternative, la réalisation des éléments de protection latéraux peut comporter, avant le dépôt du matériau d'encapsulation et/ou la réalisation du capot :
- réalisation de cavités dans une couche de matériau non solidaire du support ;
- dépôt du matériau opaque dans les cavités, formant les éléments de protection latéraux;
- découpe de la couche de matériau, formant le ou les premiers blocs de matériau ;
- disposition du ou des premiers blocs de matériau sur le support, autour de la ou des puces ;
et le matériau d'encapsulation peut ensuite être déposé en recouvrant le ou les premiers blocs de matériau et/ou au-dessus duquel ou desquels le capot est ensuite réalisé ou disposé.

Le procédé peut comporter en outre, après l'étape de couplage de la ou des puces :
- réalisation d'au moins une couche de protection avant du boîtier-système électronique du côté d'une face avant du boîtier-système électronique et en regard de la ou des puces, la couche de protection avant comprenant plusieurs portions de matériau électriquement conducteur s'étendant dans au moins un plan parallèle à la face avant du boîtier-système électronique selon au moins un motif de serpentin.

Le procédé peut comporter en outre, avant l'étape de couplage de la ou des puces, la réalisation d'une couche de redistribution sur la face avant du support et/ou au moins en partie dans le support, et dans lequel :
- la ou les puces sont couplées ensuite électriquement à la couche de redistribution ;
- le procédé comporte une étape de réalisation d'éléments de connexion reliant électriquement la couche de protection avant à la couche de redistribution, entourés par les éléments de protection latéraux et disposés dans le matériau d'encapsulation ou dans au moins un deuxième bloc de matériau distinct du su pport.

Dans ce cas, les étapes mises en œuvre pour réaliser les éléments de protection latéraux sont avantageusement utilisées pour réaliser également les éléments de connexion, que ceux-ci soient réalisés directement dans le matériau d'encapsulation ou dans des blocs de matériau distincts du support.

Le matériau des éléments de protection latéraux peut être électriquement conducteur, et des premières portions de la couche de redistribution peuvent former des éléments de liaison électrique reliant électriquement au moins une partie des éléments de protection latéraux entre eux, et les éléments de protection latéraux peuvent être reliés électriquement aux portions de matériau électriquement conducteur de la couche de protection avant en formant un ou plusieurs chemins de conduction dont l'impédance ou la résistance électrique peut être mesurée.

L'invention concerne également un procédé de réalisation de plusieurs boîtiers-systèmes électroniques, dans lequel chacun des boîtiers-systèmes électroniques est réalisé en mettant en œuvre les étapes d'un procédé tel que décrit précédemment, et dans lequel, dans chacun des boîtiers-systèmes électroniques, les éléments de liaison électriques sont agencés dans plusieurs premiers blocs de matériau et forment, avec les éléments de protection latéraux et les portions de matériau électriquement conducteur de la couche de protection avant, des chemins de conduction différents d'un boîtier-système électronique à l'autre.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent schématiquement un boîtier-système électronique respectivement selon un premier, deuxième et troisième mode de réalisation ;
- la figure 4 représente schématiquement plusieurs éléments de connexion reliant électriquement des éléments de protection latéraux d'un boîtier-système électronique selon l'invention ;
- les figures 5 à 8 représentent une partie des étapes d'un procédé de réalisation d'un boîtier-système électronique selon l'invention ;
- les figures 9 à 11 représentent des étapes mises en œuvre pour réaliser des éléments de connexion reliant électriquement des éléments de protection latéraux selon une configuration avantageuse ;
- la figure 12 représente schématiquement un boîtier-système électronique selon un quatrième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIER

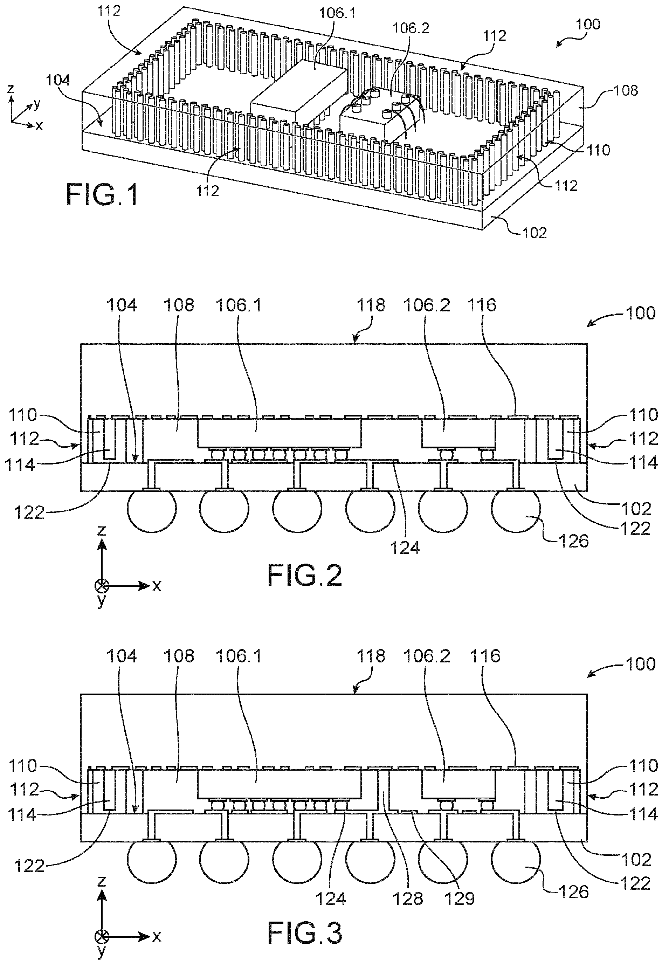

Un boîtier-système électronique 100 selon un premier mode de réalisation est décrit ci-dessous en lien avec la figure 1.

Le boîtier-système électronique 100 comporte un support 102 correspondant par exemple à un substrat semi-conducteur tel que du silicium ou un substrat céramique ou métallique ou encore organique.

Le boîtier-système électronique 100 comporte également des puces couplées mécaniquement et électriquement à une face avant 104 du support 102. Sur l'exemple de réalisation représenté sur la figure 1, le boîtier-système électronique 100 comporte une première puce portant la référence 106.1 et couplée mécaniquement et électriquement à la face avant 104 par flip-chip, ou puce retournée, et une deuxième puce portant la référence 106.2 et dont le couplage électrique avec la face avant 104 est réalisé par câblage filaire. En variante, il est possible que le boîtier-système électronique 100 comporte un plus grand nombre de puces couplées mécaniquement et électriquement à la face avant 104 du support 102, ou bien encore une seule puce couplée mécaniquement et électriquement à la face avant 104 du support 102.

Le boîtier-système 100 comporte également un matériau d'encapsulation 108 recouvrant la face avant 104 du support 102 et encapsulant les puces 106.1, 106.2. Le matériau d'encapsulation 108 correspond par exemple à une résine.

Le boîtier-système 100 comporte également plusieurs éléments de protection latéraux 110 comprenant un matériau opaque, entourant latéralement les puces 106.1, 106.2 et configurés pour former une barrière au moins vis-à-vis d'attaques par laser réalisées à travers des faces latérales 112 du boîtier-système électronique 100 qui sont sensiblement perpendiculaires à la face avant 104 du support 102. Sur l'exemple représenté sur la figure 1, chaque élément de protection latéral 110 a une forme de pilier disposé sur la face avant 104 du support 102, et comporte une section, dans un plan parallèle à la face avant 104 du support 102 (plan parallèle au plan (X,Y) de la figure 1), par exemple de forme circulaire, ovale, polygonale, etc. Chaque élément de protection latéral 110 a par exemple un diamètre compris entre environ 10 µm et 100 µm.

Dans le premier mode de réalisation représenté sur la figure 1, les éléments de protection latéraux 110 sont disposés directement dans le matériau d'encapsulation 108, c'est-à-dire formés dans des cavités traversant le matériau d'encapsulation 108.

Afin d'assurer une bonne protection latérale des puces 106.1, 106.2, la hauteur (dimension selon l'axe Z et perpendiculaire à la face avant 104 du support 102) de chaque élément de protection latéral 110 est au moins égale à celle des puces 106.1, 106.2 afin que ces éléments de protection latéraux 110 forment une barrière au niveau des côtés du boîtier-système électronique 100.

Le matériau des éléments de protection latéraux 110 correspond avantageusement à un matériau électriquement conducteur, ce qui permet de former une barrière de protection vis-à-vis des attaques par laser mais également des attaques par ondes électromagnétiques. Ce matériau électriquement conducteur peut correspondre avantageusement à un matériau magnétique, comme par exemple du NiFe ou du CoZaTr, ou à une combinaison de matériaux magnétiques et non-magnétiques permettant l'utilisation d'effet de type GMI (Giant Magnétolmpédance). L'utilisation d'un matériau magnétique pour former au moins en partie les éléments de protection latéraux 110 permet d'améliorer l'efficacité du blindage électromagnétique réalisé par les éléments 110.

En variante, il est possible que ce matériau opaque des éléments de protection latéraux ne soit pas électriquement conducteur, comme par exemple un matériau polymère. Dans ce cas, la barrière de protection formée par les éléments de protection latéraux protège les puces 106.1, 106.2 vis-à-vis des attaques par laser, mais pas vis-à-vis des attaques par ondes électromagnétiques.

Le matériau des éléments de protection latéraux 110 est opaque vis-à-vis d'au moins un faisceau laser de longueur d'onde comprise entre 360 nm et 1064 nm.

Sur la figure 1, au niveau de chacune des faces latérales 112 du boîtier-système électronique 100, les éléments de protection latéraux 110 sont disposés en quinconce et en plusieurs rangées (deux sur la figure 1) parallèles à ladite face latérale 112 du boîtier-système électronique 100. Une telle configuration forme un obstacle supplémentaire vis-à-vis d'une attaque qui serait réalisée à travers les faces latérales du boîtier-système électronique 100.

Bien que non visibles sur la figure 1, le boîtier-système électronique 100 comporte également des éléments de contact électrique disposés au niveau d'une face arrière, opposée à la face avant 104, du support 102 et couplés électriquement aux puces 106.1, 106.2.

Un boîtier-système électronique 100 selon un deuxième mode de réalisation est décrit ci-dessous en lien avec la figure 2.

Comme dans le premier mode de réalisation, le boîtier-système électronique 100 comporte le support 102, les puces 106.1 et 106.2 couplées mécaniquement et électriquement à la face avant 104 du support 102, le matériau d'encapsulation 108 et les éléments de protection latéraux 110.

Par rapport au premier mode de réalisation, les éléments de protection latéraux 110 du boîtier-système électronique 100 selon le deuxième mode de réalisation ne sont pas réalisés directement dans le matériau d'encapsulation 108, mais sont disposés dans des premiers blocs 114 de matériau distinct du support 102 et disposés dans le matériau d'encapsulation 108. Le matériau des premiers blocs 114 correspond par exemple à un semi-conducteur tel que du silicium. En variante, le matériau des premiers blocs 114 peut correspondre à un matériau opaque tel que du polymère.

Le boîtier-système électronique 100 selon le deuxième mode de réalisation comporte en outre une couche de protection avant 116 disposée dans le matériau d'encapsulation 108, du côté d'une face avant 118 du boîtier-système électronique 100 et en regard des puces 106.1, 106.2. La couche de protection avant 116 comprend plusieurs portions de matériau électriquement conducteur s'étendant dans au moins un plan parallèle à la face avant 118 du boîtier-système électronique 100 selon au moins un motif de serpentin. La couche de protection avant 116 est également parallèle à la face avant 104 du support 102.

De plus, le boîtier-système électronique 100 selon le deuxième mode de réalisation comporte en outre des éléments de liaison électrique 122 disposés entre le support 102 et les éléments de protection latéraux 110. Chacun des éléments de liaison électrique 122 relie électriquement au moins une partie des éléments de protection latéraux 110 entre eux.

Les éléments de protection latéraux 110, lorsqu'ils sont électriquement conducteurs, peuvent également être reliés électriquement, au niveau de leurs sommets, aux portions de matériau électriquement conducteur de la couche de protection avant 116 en formant un ou plusieurs chemins de conduction dont l'impédance ou la résistance électrique peut être mesurée : lorsque les éléments de protection latéraux 110 et la couche de protection avant 116 sont parcourus par un courant électrique continu, la résistance électrique de ce ou ces chemins de conduction est mesurée, et lorsque ce courant est alternatif, l'impédance de ce ou ces chemins de conduction est mesurée.

Ainsi, les éléments de protection latéraux 110 forment, avec la couche de protection avant 116, un ensemble dont l'intégrité peut être vérifiée en mesurant la valeur de la ou des résistances ou impédances du ou des chemins de conduction formés.

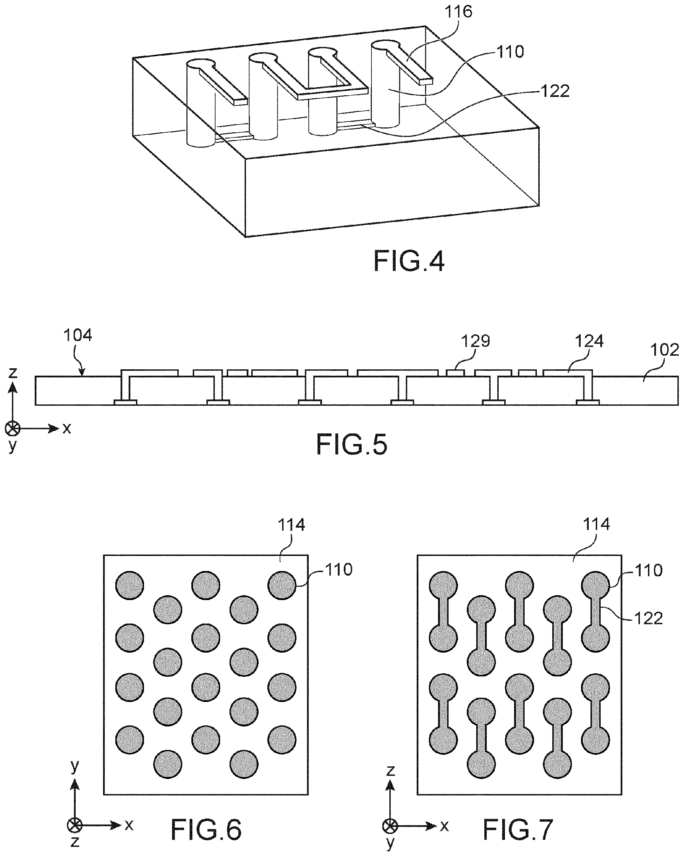

La figure 4 représente schématiquement plusieurs éléments de protection latéraux 110 couplés électriquement deux à deux par des éléments de liaison électrique 122. Les sommets des éléments de protection latéraux 110 sont couplés électriquement à des portions de matériau électriquement conducteur de la couche de protection avant 116.

Le boîtier-système 100 selon le deuxième mode de réalisation comporte en outre une couche de redistribution 124 interposée entre la face avant 104 du support 102 et les puces 106.1, 106.2 et/ou disposée au moins en partie dans le support 102, et à laquelle les puces 106.1, 106.2 sont reliées électriquement. Cette couche de redistribution 124 assure les liaisons électriques entre les puces 106.1, 106.2 ainsi que celles entre les puces 106.1, 106.2 et des éléments de contact électrique 126 du boîtier-système 100 qui correspondent, sur l'exemple représenté sur la figure 2, à des billes de matériau fusible (ou « solder balls » en anglais). Dans le cas où les éléments de protection latéraux 110 sont réalisés directement dans le matériau d'encapsulation 108, les éléments de liaison électrique 122 correspondent à des portions de la couche de redistribution 124. Dans le cas où les éléments de protection latéraux 110 sont réalisés dans des blocs 104 de matériau distinct du support, ces éléments de liaison électrique 122 peuvent faire partie intégrante desdits blocs 104 ou correspondre là aussi à des portions de la couche de redistribution 124.

Un boîtier-système 100 selon un troisième mode de réalisation est décrit ci-dessous en lien avec la figure 3.

Le boîtier-système 100 selon ce troisième mode de réalisation comporte tous les éléments du boîtier-système 100 selon le deuxième mode de réalisation précédemment décrit. Par contre, le boîtier-système 100 selon le troisième mode de réalisation comporte également des éléments de connexion 128 reliant électriquement la couche de protection avant 116 à la couche de redistribution 124. Sur la figure 3, un seul élément de connexion 128 est représenté. Les éléments de connexion 128 sont par exemple disposés entre les puces 106.1, 106.2. Plus généralement les éléments de connexion 128 sont entourés par les éléments de protection latéraux 110 et sont disposés dans le matériau d'encapsulation 108 ou entre le support et le capot.

Les éléments de connexion 128 comportent avantageusement un matériau similaire à celui des éléments de protection latéraux 110, et peuvent avoir une forme et des dimensions similaires à celles des éléments de protection latéraux 110. Des éléments de connexion similaires aux éléments de connexion 128 peuvent également servir de protection interne au boîtier-système 100, en formant un blindage autour de certaines parties du boîtier-système 100 qui ne doivent pas recevoir d'ondes électromagnétique provenant d'autres parties du boîtier-système 100.

Selon une autre variante, les éléments de connexion 128 peuvent être disposés dans au moins un deuxième bloc de matériau distinct du support 102 et disposé dans le matériau d'encapsulation 108, de manière analogue aux éléments de protection latéraux 110. Dans cette variante, lorsque le matériau du ou des deuxièmes blocs de matériau correspond à du silicium, les éléments de connexion 128 peuvent correspondre à des vias traversant ou TSV (« Through-Silicon Via » en anglais)

Dans les premier et deuxième modes de réalisation précédemment décrits, les éléments de contact électrique 126 présents en regard des puces 106.1, 106.2 assurent également une protection de la face arrière du boîtier-système 100. Sur l'exemple de réalisation représenté sur la figure 3, des portions de la couche de redistribution 124 forment une couche de protection arrière 129 du boîtier-système électronique 100, du côté opposé à la face avant 118, cette couche de protection arrière 129 étant distincte des éléments de contact électrique 126.

De manière avantageuse, les éléments de protection latéraux 110 sont également reliés électriquement à la couche de protection arrière 129. Ainsi, les éléments de protection latéraux 110, la couche de protection avant 116 et la couche de protection arrière 129 forment une protection globale au niveau de toutes les faces du boîtier-système électronique 100, protégeant toutes les faces des puces 106.1, 106.2. La présence de cette couche de protection arrière 129 permet d'améliorer la protection par rapport à la seule présence des éléments de contact électrique 126.

Un procédé de réalisation du boîtier-système électronique 100 est décrit ci-dessous en lien avec les figures 5 à 8.

La couche de redistribution 124 est tout d'abord réalisée sur le support 102 (figure 5). Dans l'exemple de réalisation décrit ici, le support 102 correspond à un substrat. Pour cela, une couche métallique est déposée sur la face avant 104 du support 102, puis une étape de photolithographie et une étape de gravure sont mises en œuvre afin que les portions restantes de la couche métallique forment la couche de redistribution 124. Comme cela est visible sur la figure 5, des portions conductrices traversent le support 102 afin qu'ultérieurement, les éléments de contact électrique 126 qui seront réalisés du côté de la face arrière du support 102 soient couplés électriquement à la couche de redistribution 124.

En variante, la couche de redistribution 124 peut être réalisée au moins en partie dans le support 102.

Des portions de la couche de redistribution 124 ne servent pas à former des connexions électriques avec les puces du boîtier-système 100 mais servent à former une couche de protection arrière 129 du côté opposé à la face avant 118 du boîtier-système 100. Pour cela, l'étape de photolithographie est mise en œuvre en incluant le motif de ces portions formant la couche de protection arrière 129.

Lorsque les éléments de protection latéraux 110 sont destinés à être réalisés dans des premiers blocs 114 et non directement dans le matériau d'encapsulation 108, ces éléments 110 sont réalisés dans les premiers blocs 114 préalablement au dépôt du matériau d'encapsulation 108. Pour cela, une couche de matériau, par exemple un substrat de semi-conducteur tel que du silicium, est utilisée. Des cavités sont réalisées dans cette couche de matériau, par exemple par gravure, formant des emplacements pour les éléments 110. Le matériau opaque destiné à former les éléments 110 est ensuite déposé (par exemple par dépôt électrochimique, sérigraphie, laminage sous vide...) dans les cavités. Le matériau opaque déposé en dehors des cavités peut être supprimé, par exemple par polissage. La couche de matériau est ensuite découpée pour former les blocs 114 incluant les éléments de protection latéraux 110.

De manière avantageuse, les éléments de protection latéraux 110 sont réalisés tels que dans chaque bloc 114, ils soient agencés en quinconce sur plusieurs rangées parallèles. La figure 6 représente schématiquement une partie d'un bloc 114 dans lequel cinq rangées d'éléments de protection latéraux 110 sont formées.

Avant la découpe de la couche utilisée pour former les premiers blocs 114, des éléments de liaison électrique 122 destinés à être disposés entre le support 102 et les éléments de protection latéraux 110 et à relier électriquement entre eux au moins une partie des éléments de protection latéraux 110 sont réalisés au niveau d'une face de la couche formant les blocs 114 où sont accessibles électriquement les éléments de protection latéraux. Ces éléments de liaison électrique 122 sont formés en déposant une couche de matériau conducteur puis en réalisant une photolithographie et une gravure afin que des portions restantes de cette couche de matériau conducteur forment les éléments de liaison électrique 122. Ils peuvent également être réalisés en même temps que les éléments de protection latéraux 110 par un dépôt électrolytique en présence d'un masque en résine. La figure 7 représente schématiquement la partie du bloc 114 visible sur la figure 6, avec les éléments de liaison électrique 122 qui ont été réalisés sur la face du bloc 114 destinée à être disposée ensuite contre le support 102.

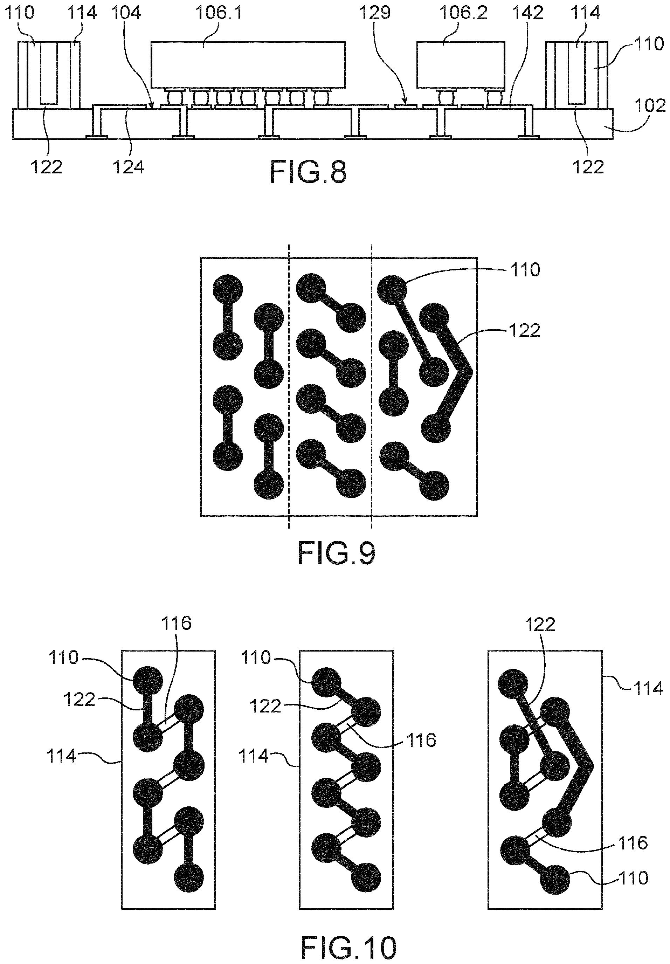

Comme représenté sur la figure 8, les puces 106.1, 106.2 sont couplées mécaniquement et électriquement à la face avant 104 du support 102. Les premiers blocs 114 sont également couplés à la face avant 104 du support 102 autour des puces 106.1, 106.2. En étant disposé sur la face avant 104 du support 102, les éléments de liaison 122 forment des portions de la couche de protection arrière 129. Lorsque le boîtier-système 100 comporte un ou plusieurs éléments de connexion 128 réalisés dans des deuxièmes blocs de matériau distincts du support 102, ces deuxièmes blocs sont également couplés à la face avant 104 du support 102 avant le dépôt du matériau d'encapsulation 108 et/ou la réalisation du capot.

Lorsque le boîtier-système 100 ne comporte pas de couche de protection avant 116, le matériau d'encapsulation 108 est ensuite déposé du côté de la face avant 104 du support 102 de manière à recouvrir les puces 106.1, 106.2 et les premiers blocs 114 dans lesquels les éléments de protection latéraux 110 ont été réalisés.

Selon un exemple de réalisation, lorsque le boîtier-système 100 est destiné à comporter la couche de protection avant 116, une première partie du matériau d'encapsulation 108 est déposée puis planarisée avec arrêt sur les premiers blocs 114 (et éventuellement les deuxièmes blocs) de manière à ce que les sommets des éléments de protection latéraux 110 (et éventuellement du ou des éléments de connexion 128) soient accessibles électriquement. La couche de protection avant 116 est ensuite réalisée sur la première partie du matériau d'encapsulation 108 et en regard de la ou des puces 106.1, 106.2. La réalisation de cette couche de protection avant 116 comporte notamment le dépôt d'une couche de matériau électriquement conducteur puis une lithographie et une gravure de cette couche de matériau électriquement conducteur. La lithographie et la gravure sont notamment mises en œuvre de manière à ce que les portions restantes de cette couche de matériau électriquement conducteur, après la gravure, forment le motif de protection souhaité, par exemple, un ou plusieurs serpentins, et également telles que les éléments de protection latéraux 110 soient reliés électriquement aux portions de matériau électriquement conducteur de la couche de protection avant 116 en formant un ou plusieurs chemins de conduction dont l'impédance ou la résistance électrique peut être mesurée.

Une deuxième partie du matériau d'encapsulation est ensuite déposée en recouvrant notamment la couche de protection avant 116, achevant ainsi la réalisation de la couche de matériau d'encapsulation 108.

En variante du procédé décrit ci-dessus, lorsque les éléments de protection latéraux 110 sont destinés à être réalisés directement dans le matériau d'encapsulation 108 qui peut être opaque, des cavités formant les emplacements des éléments de protection latéraux 110 sont gravées dans le matériau d'encapsulation 108, après le dépôt de celui-ci, par exemple par gravure plasma ou par laser. Le matériau opaque destiné à former les éléments de protection latéraux 110 est ensuite déposé dans ces cavités. Le matériau déposé en dehors de ces cavités peut être supprimé par la mise en œuvre d'une planarisation avec arrêt sur le matériau d'encapsulation 108.

De manière avantageuse, lorsque les éléments de protection latéraux 110 sont réalisés dans les premiers blocs 114, les éléments de liaison électriques 122 qui relient électriquement entre eux au moins une partie des éléments de protection latéraux 110 sont agencés différemment dans chacun des premiers blocs 114. Cette configuration permet d'obtenir une circulation différente du courant dans les éléments de protection latéraux 110 et ainsi des valeurs différentes d'impédance, apportant ainsi une différence à la valeur de l'impédance du circuit électrique formé par les éléments de protection latéraux 110.

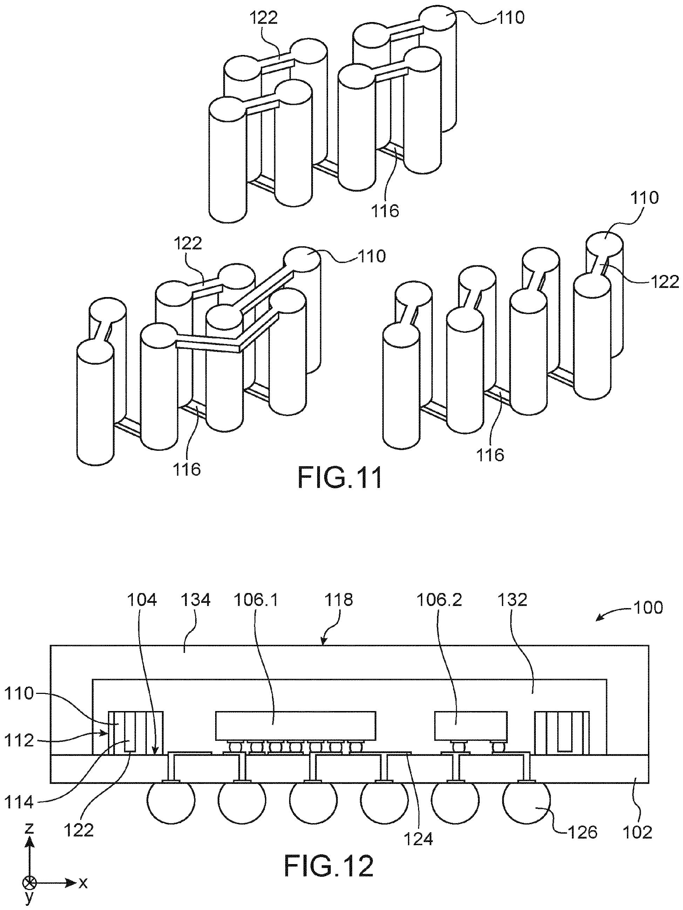

Une telle configuration est par exemple obtenue en réalisant tout d'abord une lithographie et une gravure permettant de définir, dans la couche de matériau servant à la réalisation des premiers blocs 114, des éléments de liaison électrique 122 agencés de manière irrégulière. Une telle configuration est représentée schématiquement sur la figure 9 pour une partie de la couche de matériau utilisée. Des premiers blocs 114 ayant des designs différents sont ensuite découpés dans cette couche, puis reportés afin d'obtenir une particularisation entre les différents modules 100. La figure 10 représente trois exemples de premiers blocs 114 obtenus à partir de la partie de la couche de matériau visible sur la figure 9. Lors de la réalisation de la couche de protection avant 116, les chemins de conduction formés par les éléments de protection latéraux 110, les éléments de liaison électrique 122 et les portions conductrices de la couche de protection avant 116 sont différents d'un premier bloc 114 à l'autre, comme cela est visible pour les premiers blocs 114 représentés sur la figure 11. De cette manière, en reportant dans les différents boîtiers-systèmes 100, des premiers blocs 114 présentant des découpes différentes, on obtient des chemins de conduction différents d'un boîtier-système 100 à l'autre et donc une particularisation des structures de protection, ce qui en renforce l'efficacité.

Dans les modes de réalisation précédemment décrits, les éléments de liaison électrique 122 qui relient électriquement entre eux les éléments de protection latéraux 110 sont disposés entre le support 102 et les éléments de protection latéraux 110. En variante, il est possible que ces éléments de liaison électrique 122 soient disposés au même niveau que la couche de protection avant 116.

Un boîtier-système électronique 100 selon un quatrième mode de réalisation est décrit ci-dessous en lien avec la figure 12.

Contrairement aux modes de réalisation précédemment décrits dans lesquels les éléments de protection latéraux 110 sont disposés soit directement dans le matériau d'encapsulation 108, soit dans les premiers blocs 114 eux-mêmes disposés dans le matériau d'encapsulation 108, le boîtier-système 100 selon le quatrième mode de réalisation ne comporte pas de matériau d'encapsulation 108. Les puces 106.1, 106.2 sont ici disposées dans une cavité 132 formée entre le support 102 et un capot 134 reposant sur le support 102. Les premiers blocs 114 sont également disposés dans la cavité 132.

Dans une variante de ce quatrième mode de réalisation, le boîtier-système électronique 100 comporte le capot 134 et également le matériau d'encapsulation 108. Dans ce cas, le boîtier-système 100 est réalisé comme précédemment décrit en lien avec les figures 5 à 8, avec le matériau d'encapsulation 108 réalisé tel qu'il encapsule les puces 106.1, 106.2. Ensuite, le capot 134 est reporté sur l'ensemble précédemment réalisé, en recouvrant le matériau d'encapsulation 108, et est solidarisé au support 102.

Dans les modes de réalisation précédemment décrits, les éléments de contact électrique 126 du boîtier-système 100 correspondent à des billes de matériau fusible. En variante, le boîtier-système 100 peut comporter des éléments de contact électrique 126 de type autre que des billes, par exemples des broches, des pattes, etc.

## Revendications

1. Boîtier-système électronique (100), comportant au moins :
- un support (102) ;
- une ou plusieurs puces (106.1, 106.2) couplées mécaniquement et électriquement à une face avant (104) du support (102) ;
- des éléments de contact électrique (126) disposés au niveau d'une face arrière, opposée à la face avant (104), du support (102) et couplés électriquement à la ou aux puces (106.1, 106.2) ;
- un matériau d'encapsulation (108) recouvrant la face avant (104) du support (102) et encapsulant la ou les puces (106.1, 106.2), et/ou un capot (134) formant, au moins avec le support (102), au moins une cavité (132) dans laquelle la ou les puces (106.1, 106.2) sont disposées ;
- plusieurs éléments de protection latéraux (110), entourant latéralement la ou les puces (106.1, 106.2) et configurés pour former une barrière au moins vis-à-vis d'attaques par laser réalisées à travers des faces latérales (112) du boîtier-système électronique (100) qui sont sensiblement perpendiculaires à la face avant (104) du support (102) ;
dans lequel les éléments de protection latéraux (110) sont disposés dans le matériau d'encapsulation (108) ou dans un ou plusieurs premiers blocs (114) de matériau distincts du support (102) et disposés dans le matériau d'encapsulation (108) et/ou entre le support (102) et le capot (134) ;
et dans lequel les éléments de protection latéraux (110) comportent au moins un matériau opaque vis-à-vis d'un faisceau laser de longueur d'onde comprise entre 360 nm et 1064 nm.

2. Boîtier-système électronique (100) selon la revendication 1, dans lequel les éléments de protection latéraux comportent au moins un matériau électriquement conducteur.

3. Boîtier-système électronique (100) selon la revendication 2, comportant en outre au moins une couche de protection avant (116) du boîtier-système électronique (100), disposée dans le matériau d'encapsulation (108), du côté d'une face avant (118) du boîtier-système électronique (100) et en regard de la ou des puces (106.1, 106.2), et comprenant plusieurs portions de matériau électriquement conducteur s'étendant dans au moins un plan parallèle à la face avant (118) du boîtier-système électronique (100) selon au moins un motif de serpentin.

4. Boîtier-système électronique (100) selon l'une des revendications précédentes, comportant en outre une couche de redistribution (124) interposée entre la face avant (104) du support (102) et la ou les puces (106.1, 106.2) et/ou disposée au moins en partie dans le support (102), et à laquelle la ou les puces (106.1, 106.2) sont reliées électriquement.

5. Boîtier-système électronique (100) selon la revendication 4, dans lequel des première portions de la couche de redistribution (124) forment des éléments de liaison électrique (122) reliant électriquement au moins une partie des éléments de protection latéraux (110) entre eux, et dans lequel, lorsque le boîtier-système électronique (100) comporte la couche de protection avant (116), les éléments de protection latéraux (110) sont reliés électriquement aux portions de matériau électriquement conducteur de la couche de protection avant (116) en formant un ou plusieurs chemins de conduction dont l'impédance ou la résistance électrique peut être mesurée.

6. Boîtier-système électronique (100) selon les revendications 3 et 4 ou selon les revendications 3 et 5, comportant en outre des éléments de connexion (128) reliant électriquement la couche de protection avant (116) à la couche de redistribution (124), entourés par les éléments de protection latéraux (110) et disposés dans le matériau d'encapsulation (108) ou dans au moins un deuxième bloc de matériau distinct du support (102) et disposé dans le matériau d'encapsulation (108).

7. Boîtier-système électronique (100) selon l'une des revendications 4 à 6, dans lequel des deuxièmes portions de la couche de redistribution (124) forment au moins une couche de protection arrière (129) du boîtier-système électronique (100) disposée en regard de la ou des puces (106.1, 106.2), lesdites deuxièmes portions de la couche de redistribution (124) étant reliées électriquement aux éléments de protection latéraux (110).

8. Boîtier-système électronique (100) selon l'une des revendications précédentes, dans lequel, au niveau de chacune des faces latérales (112) du boîtier-système électronique (100), les éléments de protection latéraux (110) sont disposés en quinconce et en plusieurs rangées parallèles à ladite face latérale (112) du boîtier-système électronique (100).

9. Procédé de réalisation d'un boîtier-système électronique (100), comportant au moins les étapes suivantes :
- couplage mécanique et électrique d'une ou plusieurs puces (106.1, 106.2) à au moins une face avant (104) d'un support (102) ;
- dépôt d'un matériau d'encapsulation (108) recouvrant la face avant (104) du support (102) et encapsulant la ou les puces (106.1, 106.2), et/ou réalisation d'un capot (134) formant, au moins avec le support (102), au moins une cavité (132) dans laquelle la ou les puces (106.1, 106.2) sont disposées ;
- réalisation d'éléments de contact électrique (126) disposés au niveau d'une face arrière, opposée à la face avant (104), du support (102) et couplés électriquement à la ou aux puces (106.1, 106.2) ;
et comportant en outre la réalisation de plusieurs éléments de protection latéraux (110) comprenant au moins un matériau opaque, entourant latéralement la ou les puces (106.1, 106.2) et configurés pour former une barrière au moins vis-à-vis d'attaques par laser réalisées à travers des faces latérales (112) du boîtier-système électronique (100) qui sont sensiblement perpendiculaires à la face avant (104) du support (102), les élément de protection latéraux (110) étant disposés dans le matériau d'encapsulation (108) ou dans un ou plusieurs premiers blocs (114) de matériau distincts du support (102) et disposés dans le matériau d'encapsulation (108) et/ou entre le support (102) et le capot (134) ;
et dans lequel les éléments de protection latéraux (110) comportent au moins un matériau opaque vis-à-vis d'un faisceau laser de longueur d'onde comprise entre 360 nm et 1064 nm.

10. Procédé selon la revendication 9, dans lequel la réalisation des éléments de protection latéraux (110) comporte, après le dépôt du matériau d'encapsulation (108) :
- réalisation de cavités dans le matériau d'encapsulation (108) ;
- dépôt du matériau opaque dans les cavités, formant les éléments de protection latéraux (110).

11. Procédé selon la revendication 9, dans lequel la réalisation des éléments de protection latéraux (110) comporte, avant le dépôt du matériau d'encapsulation (108) et/ou la réalisation du capot (134) :
- réalisation de cavités dans une couche de matériau non solidaire du support ;
- dépôt du matériau opaque dans les cavités, formant les éléments de protection latéraux (110) ;
- découpe de la couche de matériau, formant le ou les premiers blocs de matériau (114) ;
- disposition du ou des premiers blocs de matériau (114) sur le support (102), autour de la ou des puces (106.1, 106.2) ;
et dans lequel le matériau d'encapsulation (108) est ensuite déposé en recouvrant le ou les premiers blocs de matériau (114) et/ou dans lequel le capot (134) est ensuite réalisé au-dessus du ou des premiers blocs de matériau (114).

12. Procédé selon l'une des revendications 9 à 11, comportant en outre, après l'étape de couplage de la ou des puces (106.1, 106.2) :
- réalisation d'au moins une couche de protection avant (116) du boîtier-système électronique (100) du côté d'une face avant (118) du boîtier-système électronique (100) et en regard de la ou des puces (106.1, 106.2), la couche de protection avant (116) comprenant plusieurs portions de matériau électriquement conducteur s'étendant dans au moins un plan parallèle à la face avant (118) du boîtier-système électronique (100) selon au moins un motif de serpentin.

13. Procédé selon la revendication 12, comportant en outre, avant l'étape de couplage de la ou des puces (106.1, 106.2), la réalisation d'une couche de redistribution (124) sur la face avant (104) du support (102) et/ou au moins en partie dans le support (102), et dans lequel :
- la ou les puces (106.1, 106.2) sont couplées ensuite électriquement à la couche de redistribution (124) ;
- le procédé comporte une étape de réalisation d'éléments de connexion (128) reliant électriquement la couche de protection avant (116) à la couche de redistribution (124), entourés par les éléments de protection latéraux (110) et disposés dans le matériau d'encapsulation (108) ou dans au moins un deuxième bloc de matériau distinct du support (102).

14. Procédé selon l'une des revendications 12 ou 13, dans lequel :
- le matériau des éléments de protection latéraux est électriquement conducteur, et
- des premières portions de la couche de redistribution (124) forment des éléments de liaison électrique (122) reliant électriquement au moins une partie des éléments de protection latéraux (110) entre eux, et dans lequel les éléments de protection latéraux (110) sont reliés électriquement aux portions de matériau électriquement conducteur de la couche de protection avant (116) en formant un ou plusieurs chemins de conduction dont l'impédance ou la résistance électrique peut être mesurée.

15. Procédé de réalisation de plusieurs boîtiers-systèmes électroniques (100), dans lequel chacun des boîtiers-systèmes électroniques (100) est réalisé en mettant en œuvre les étapes d'un procédé selon les revendications 11 et 14, et dans lequel, dans chacun des boîtiers-systèmes électroniques (100), les éléments de liaison électriques (122) sont agencés dans plusieurs premiers blocs de matériau (114) et forment, avec les éléments de protection latéraux (110) et les portions de matériau électriquement conducteur de la couche de protection avant (116), des chemins de conduction différents d'un boîtier-système électronique (100) à l'autre.
